(19) Europäisches Patentamt
European Patent Office
Office européen des brevets

(11) **EP 4 651 647 A1**

(12) **EUROPEAN PATENT APPLICATION**
published in accordance with Art. 153(4) EPC

(43) Date of publication:
**19.11.2025 Bulletin 2025/47**

(21) Application number: **23923800.9**

(22) Date of filing: **27.11.2023**

(51) International Patent Classification (IPC):
*H05K 5/02* (2006.01)

(86) International application number:
**PCT/CN2023/134509**

(87) International publication number:
**WO 2024/174637 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.02.2023 CN 202310201364**

(71) Applicant: **Huawei Technologies Co., Ltd.**
**Shenzhen, Guangdong 518129 (CN)**

(72) Inventors:
• WANG, Huijuan
 Shenzhen, Guangdong 518129 (CN)
• LI, Hangfei
 Shenzhen, Guangdong 518129 (CN)
• ZHU, Taishan
 Shenzhen, Guangdong 518129 (CN)
• WEI, Xiaosong
 Shenzhen, Guangdong 518129 (CN)
• GUO, Yu
 Shenzhen, Guangdong 518129 (CN)
• DING, Yuwei
 Shenzhen, Guangdong 518129 (CN)

(74) Representative: **Maiwald GmbH**
**Engineering**
**Elisenhof**
**Elisenstrasse 3**
**80335 München (DE)**

(54) **SHELL STRUCTURE, SHELL, ELECTRONIC DEVICE, AND PREPARATION METHOD FOR SHELL STRUCTURE**

(57) This application discloses an enclosure structure, an enclosure, an electronic device, and an enclosure structure preparation method. The enclosure structure may include a first area and a second area. The first area and the second area are of an integrally formed structure. Therefore, the enclosure structure has good mechanical performance. The second area includes glass-ceramic and a metal cluster. The metal cluster is used as a crystal nucleus of the glass-ceramic, and helps form the glass-ceramic, so that the second area may have a large crystallinity. A crystallinity is inversely related to a transmittance. The second area has a large crystallinity, and correspondingly, the second area has a small transmittance. The second area having a small transmittance may block propagation of an interference signal to an extent, to reduce the interference signal.

FIG. 4

**Description**

This application claims priority to Chinese Patent Application No. 202310201364.5, filed with the China National Intellectual Property Administration on February 22, 2023 and entitled "ENCLOSURE STRUCTURE, ENCLOSURE, ELECTRONIC DEVICE, AND ENCLOSURE STRUCTURE PREPARATION METHOD", which is incorporated herein by reference in its entirety.

**TECHNICAL FIELD**

This application relates to the technical field of enclosure structures of electronic devices, and specifically, to an enclosure structure, an enclosure, an electronic device, and an enclosure structure preparation method.

**BACKGROUND**

An electronic device may include an enclosure and an optical sensor disposed inside the enclosure. As a sensor commonly used in the electronic device, the optical sensor (opto-sensor) may include one or more optical components. The optical component may be configured as a component that emits or monitors an optical signal in a specified wavelength range. The enclosure includes at least one enclosure structure. For example, the enclosure structure may include a frame, a cover plate, and a bottom plate.

The electronic device may process an optical signal detected by the optical sensor, to implement some functions. A process in which the electronic device implements some functions by using the optical signal detected by the optical sensor is as follows: A light emitter emits the optical signal; the optical signal is transmitted through the enclosure structure and is incident to a target object; and the optical signal that is absorbed, reflected, or refracted by the target object may be transmitted through the enclosure structure and returned to an optical receiver. The optical signal that is absorbed, reflected, or refracted by the target object is related to a property of the target object. Therefore, the optical receiver may detect the optical signal related to the target object.

Generally, a transparent material is used for the enclosure structure. A part of the optical signal emitted by the light emitter may be transmitted to the optical receiver through a transition area. The transition area may be defined as an area between an area in which a projection of the light emitter on the enclosure structure is located and an area in which a projection of the optical receiver on the enclosure structure is located. The optical signal transmitted through the transition area is a typical interference signal. Existence of the interference signal may decrease accuracy of a monitoring result of the optical receiver.

SUMMARY

This application discloses an enclosure structure, an enclosure, an electronic device, and an enclosure structure preparation method. The enclosure structure includes a first area and a second area, and the second area includes a metal cluster. The metal cluster included in the second area enables the second area to have a small transmittance, so that the second area can block an interference signal.

A first aspect of this application discloses an enclosure structure, including a first area and a second area, where the first area and the second area are integrally formed, a transmittance of the first area is greater than a transmittance of the second area, and the second area includes glass-ceramic and a metal cluster.

In this implementation, the enclosure structure may include the first area and the second area. The first area and the second area are of an integrally formed structure. Therefore, the enclosure structure has good mechanical performance. The second area includes the glass-ceramic and the metal cluster. The metal cluster is used as a crystal nucleus of the glass-ceramic, and helps form the glass-ceramic, so that the second area may have a large crystallinity. A crystallinity is inversely related to a transmittance. The second area has a large crystallinity, and correspondingly, the second area has a small transmittance. The second area having a small transmittance may block propagation of an interference signal inside the enclosure structure to an extent, to reduce the interference signal.

With reference to a first implementation of the first aspect, the metal cluster includes one or a combination of an Ag cluster, a Cu cluster, and an Au cluster.

With reference to a second implementation of the first aspect, a raw material used for the enclosure structure includes a photosensitive material, the photosensitive material includes a nucleating metal, the photosensitive material converts the nucleating metal that exists in a form of a compound into a nucleating metal in an atomic state under an action of an optical signal, and the nucleating metal in the atomic state is used to form the metal cluster.

In this implementation, the photosensitive material may convert, under illumination of the optical signal, the nucleating metal that exists in the form of a compound inside the photosensitive material into the nucleating metal in the atomic state, and the nucleating metal in the atomic state may be aggregated to form the metal cluster after being heated.

Therefore, a manner of partial exposure using the optical signal plus heating may be used, so that the nucleating metal that exists in the form of a compound in an exposed area is reduced to the atomic state, to form the metal cluster. In a subsequent overall heat treatment process, a part having the metal cluster is more easily crystallized to form the second area having a small transmittance, so as to obtain the first area and the second area that are integrally formed.

With reference to a third implementation of the first aspect, the photosensitive material further includes a photosensitive compound, and the photosensitive compound releases an electron under the action of the optical signal.

In this implementation, the photosensitive material further includes the photosensitive compound. The photosensitive compound releases the electron under the action of the optical signal. The electron makes the nucleating metal that exists in the form of a compound be reduced to a metal atom in a free state. In this way, the second area including the metal cluster may be obtained in the manner of partial exposure plus heating.

With reference to a fourth implementation of the first aspect, the photosensitive material further includes an anion, the anion and the nucleating metal form a light sensitive compound, and the nucleating metal in the atomic state is precipitated from the light sensitive compound under the action of the optical signal.

In this implementation, the nucleating metal in the atomic state is precipitated from the light sensitive compound under the action of the optical signal. In this way, the second area including the metal cluster may be obtained in the manner of partial exposure plus heating.

With reference to a fifth implementation of the first aspect, the raw material used for the enclosure structure includes a halogen element.

In this implementation, the halogen element in a high-temperature environment may provide an acid/oxidized gas atmosphere, to prevent the nucleating metal in the raw material from being precipitated in a form of an atom, so as to avoid forming the metal cluster in a melting process. A quantity/density of metal clusters in an unexposed area can be reduced, and a crystallinity of the unexposed area can be reduced. The first area formed by the unexposed area has a large transmittance, to ensure a small loss in a process of transmitting an effective optical signal and an emitted optical signal through the first area.

With reference to a sixth implementation of the first aspect, the first area includes the glass-ceramic and/or common glass.

With reference to a seventh implementation of the first aspect, the second area penetrates the enclosure structure.

In this implementation, the second area penetrates the enclosure structure, and the second area may block a large quantity of interference signals.

With reference to an eighth implementation of the first aspect, a surface of the enclosure structure includes a plane, a curved surface, a protrusion, and/or a recess.

With reference to a ninth implementation of the first aspect, a light blocking layer is disposed in the recess of the second area, and a transmittance of the light blocking layer is less than the transmittance of the second area.

In this implementation, the light blocking layer is disposed in the recess on a surface of the second area. The light blocking layer and the second area are included between adjacent first areas. Because the transmittance of the light blocking layer is less than the transmittance of the second area, the light blocking layer can block a large quantity of interference signals. Therefore, the enclosure structure disclosed in this implementation can block a large quantity of interference signals.

With reference to a tenth implementation of the first aspect, the protrusion and the recess form a Fresnel pattern.

In this implementation, the Fresnel pattern formed by the protrusion/recess on the surface of the enclosure structure may play a focusing role, and a signal-to-noise ratio of the effective optical signal may be improved by designing the Fresnel pattern.

The Fresnel pattern is designed on the surface of the enclosure structure, so that the Fresnel pattern can be implemented without using an additional film, and a stacking size of the enclosure structure can be reduced.

In this implementation, the Fresnel pattern is formed by the protrusion/recess on the surface of the enclosure structure, and the Fresnel pattern and the first area/second area are integrally formed. In this way, a process interface for glue bonding, splicing, or fusion splicing is not included between the first area/second area and the Fresnel pattern. In this way, the enclosure structure has better integration and better mechanical performance.

With reference to an eleventh implementation of the first aspect, the enclosure structure includes a compressive stress layer and a tensile stress layer, and the compressive stress layer is disposed on a surface of the tensile stress layer.

The enclosure structure disclosed in this implementation includes the compressive stress layer and the tensile stress layer, and the compressive stress layer is disposed on the surface of the tensile stress layer. To be specific, the compressive stress layer located on an outer surface is subject to compressive stress, and the tensile stress layer located on an inner surface is subject to tensile stress. Existence of the compressive stress layer can block/eliminate generation and extension of a micro-print on the surface of the enclosure structure, to improve mechanical performance of the enclosure structure.

With reference to a twelfth implementation of the first aspect, the second area includes a plurality of sub-areas in contact with each other, and adjacent sub-areas have different transmittances.

In this implementation, two adjacent sub-areas have different transmittances, and a refraction/reflection interface may be formed between the two sub-areas. When the interference signal is propagated to the refraction/reflection interface, refraction/reflection occurs, so that an interference signal transmitted through the second area is reduced.

With reference to a thirteenth implementation of the first aspect, a width of the second area is greater than or equal to a specified value.

A larger width of the second area indicates a greater blocking effect of the second area on the interference signal. In this implementation, the width of the second area is greater than or equal to the specified value, so that it can be ensured that the second area has a good blocking effect on the interference signal.

With reference to a fourteenth implementation of the first aspect, the first area includes no metal cluster, or a density of a metal cluster in the first area is less than a density of the metal cluster in the second area.

In this implementation, the first area includes no metal cluster, or the density of the metal cluster in the first area is less than the density of the metal cluster in the second area. The metal cluster helps form the glass-ceramic. In this way, the first area having a small/zero crystallinity and the second area having a large crystallinity may be obtained in an overall heat treatment manner, and a warp between the first area and the second area is small. A crystallinity is inversely related to a transmittance. The first area has a small crystallinity, so that the first area has a large transmittance, to ensure a small loss in a process of transmitting the effective optical signal through the first area. The second area has a large crystallinity, and correspondingly, the second area has a small transmittance. The second area having a small transmittance may block propagation of an interference signal inside the enclosure structure to an extent, to reduce the interference signal.

With reference to a fifteenth implementation of the first aspect, if the enclosure structure includes a plurality of second areas, transmittances of any two second areas are the same, or transmittances of any two second areas are different.

A second aspect of this application discloses an enclosure structure preparation method, including: exposing a partial area of a glass plate; performing nucleation heat treatment on the exposed glass plate, so that a metal cluster is formed in the exposed area of the glass plate, where a raw material used for the glass plate includes a photosensitive material, the photosensitive material includes a nucleating metal, the photosensitive material converts the nucleating metal that exists in a form of a compound inside the photosensitive material into a nucleating metal in an atomic state under an action of an optical signal, and the nucleating metal in the atomic state is used to form the metal cluster; and performing crystallization heat treatment on the glass plate on which nucleation treatment is performed, to obtain an enclosure structure, where the enclosure structure includes a first area and a second area, the second area is obtained by crystallizing the exposed area of the glass plate, the first area is obtained by crystallizing an unexposed area of the glass plate, and the second area includes glass-ceramic and the metal cluster.

In this implementation, the glass plate is used to form the enclosure structure, and the glass plate includes the photosensitive material. Under the action of the optical signal, the nucleating metal that exists in the form of a compound inside the photosensitive material is converted into the nucleating metal in the atomic state, and the nucleating metal in the atomic state may be aggregated to form the metal cluster. In this way, a manner of partial exposure using the optical signal may be used, so that the metal cluster is formed in the exposed area. In a subsequent heat treatment process, the exposed area having the metal cluster is easily crystallized to form the second area having a small transmittance, and the second area having a small transmittance may block propagation of an interference signal inside the enclosure structure to an extent, to reduce the interference signal. According to the preparation method disclosed in this implementation, the first area having a small/zero crystallinity and the second area having a large crystallinity may be obtained in an overall heat treatment manner, and a warp between the first area and the second area in the prepared glass plate is small.

With reference to a first implementation of the second aspect, the step of exposing the partial area of the glass plate includes: disposing a mask reticle on a side of the glass plate, where the mask reticle includes a window, and illuminating, by the optical signal, the partial area of the glass plate through the window of the mask reticle.

In this implementation, partial exposure of the glass plate is implemented by using the mask reticle. A shape/size of the finally obtained second area is a shape/size of the window of the mask reticle. The shape/size of the second area may be flexibly configured by using mask reticles with windows having different shapes/sizes.

With reference to a second implementation of the second aspect, the step of exposing the partial area of the glass plate is specifically: illuminating the partial area of the glass plate through a laser.

In this implementation, a size and a shape of the exposed area may be controlled by controlling a laser path. In this process, no assistance of the mask reticle is required, so that costs of the enclosure structure may be reduced to an extent.

With reference to a third implementation of the second aspect, an energy flow density of the optical signal used during exposure is less than or equal to a damage threshold of the glass plate.

In this implementation, the energy flow density of the optical signal is less than or equal to the damage threshold of the glass plate, so that an internal structure of the exposed area is not damaged in the partial exposure phase.

With reference to a fourth implementation of the second aspect, after the step of performing heat treatment on the exposed glass plate to obtain the enclosure structure, the preparation method further includes: chemically strengthening the enclosure structure, so that a compressive stress layer is generated on a surface of the enclosure structure, where the compressive stress layer is disposed on a surface of a tensile stress layer.

In this implementation, there is a volume difference between the surface of the enclosure structure before chemical strengthening and the surface of the enclosure structure after chemical strengthening. The volume difference forms the compressive stress layer within a specific depth range of the enclosure structure. Existence of the compressive stress layer can block/eliminate generation and extension of a micro-print on the surface of the enclosure structure, to improve mechanical performance of the enclosure structure.

A third aspect of this application discloses an enclosure, where the enclosure includes at least one enclosure structure disclosed in the first aspect.

A fourth aspect of this application discloses an electronic device, including a light emitter, an optical receiver, and the enclosure structure disclosed in the first aspect. The enclosure structure includes a first area and a second area. The light emitter is configured to emit an optical signal that is transmitted through the first area, and the optical receiver is configured to receive the optical signal that is transmitted through the first area. The second area is located between a projection of the light emitter on the first area and a projection of the optical receiver on the first area.

With reference to a first implementation of the fourth aspect, the electronic device further includes a cover bottom layer, the cover bottom layer is disposed on an inner surface of the enclosure structure, and the cover bottom layer is disposed avoiding the projection of the optical receiver/the light emitter on the first area.

## BRIEF DESCRIPTION OF DRAWINGS

FIG. 1 shows an example of a physical diagram of a wearable device;
FIG. 2 is a diagram of an application scenario of a wearable device;
FIG. 3 is a diagram of an application scenario of an enclosure structure disclosed in a related technology;
FIG. 4 is a diagram of an enclosure structure disclosed in a feasible implementation;
FIG. 5 is a diagram of an enclosure structure disclosed in a feasible implementation;
FIG. 6 is a diagram of an enclosure structure disclosed in a feasible implementation;
FIG. 7 is a diagram of an enclosure structure disclosed in a feasible implementation;
FIG. 8 is a diagram of an enclosure structure disclosed in a feasible implementation;
FIG. 9 is a diagram of an enclosure structure disclosed in a feasible implementation;
FIG. 10 is a flowchart of an enclosure structure preparation method disclosed in a feasible implementation;
FIG. 11 is a process flowchart of an enclosure structure disclosed in a feasible implementation; and
FIG. 12 is a process flowchart of an enclosure structure disclosed in a feasible implementation.

## DESCRIPTION OF EMBODIMENTS

Reference now is made specifically to the representative implementations shown in the accompanying drawings. It should be understood that the following descriptions are not intended to limit the implementations to a preferred specific implementation. Instead, the implementations are intended to cover alternative forms, modified forms, and equivalent forms that may be included in the present disclosure and the substance and scope defined by the appended claims.

Concepts in embodiments of this application are first described.

A crystallinity (crystallinity) may be represented by R, and the crystallinity is defined as a proportion of a crystal in an area (a first area/a second area). The proportion may include a mass proportion and a volume proportion.

For example, calculation may be performed by using the following formula:

$$R = Mcrystal/(Mcrystal + Mamorphous) \times 100\%.$$

Mcrystal represents mass of the crystal included in the area, and Mamorphous represents mass of amorphous bodies included in the area.

A transmittance (transmittance) may be represented by T, and the transmittance is defined as a proportion of radiation energy of optical signals transmitted through an area to total radiation energy of optical signals projected onto the area in a process in which the optical signals are incident from an inner surface of the area and leave an outer surface of the area.

A loss of an optical signal in a propagation process in an area is related to a transmittance of the area. A larger transmittance of the area indicates a smaller loss of the optical signal in the propagation process in the area. A smaller transmittance of the area indicates a larger loss of the optical signal in the propagation process in the area.

A density of a metal cluster is defined as a quantity of metal clusters included in an area (the first area or the second area) per unit volume.

An electronic device in embodiments of this application may include but is not limited to portable electronic devices such as a wearable device (for example, an electronic band), a notebook computing device (for example, a notebook computer or a laptop computer), a tablet computing device (for example, a tablet computer), and a mobile phone (for example, a cell phone). The electronic device may alternatively be a desktop computer system, a computer component, an input device, a device, or actually any other type of electronic product or device component.

The electronic device may include an enclosure and an electronic component disposed inside the enclosure. The enclosure may include one or more enclosure structures, and the enclosure has a cavity configured to accommodate the electronic component. For example, the enclosure structure may include a cover, a frame, and a bottom plate.

In a feasible implementation, a plurality of enclosure structures may be connected together through bonding, fusion splicing, splicing, or the like, to form an enclosure.

In a feasible implementation, a plurality of enclosure structures may be of an integrally formed structure.

The electronic component may include a sensor component, a processor, and the like. The sensor component may be referred to as a sensor for short in embodiments of this application.

The processor (central processing unit, CPU) is a data processing apparatus, and may process a signal detected by the sensor, so that the electronic device implements a corresponding function. Functions of the electronic device may include but are not limited to: health management, sports measurement, social interaction, leisure games, media entertainment, and the like.

The sensor (transducer/sensor) is a monitoring apparatus that can sense measured information, and can convert the sensed information into an electrical signal or information in another required form according to a specific rule for output. The measured information may include but is not limited to an optical signal, an electrical signal, and the like.

The sensor may include but is not limited to a proximity sensor, an optical sensor (for example, a health monitoring sensor), a biometric recognition sensor (for example, a facial or fingerprint recognition sensor), a depth sensor or an imaging sensor, an audio sensing device, a touch sensor, a force sensor, an accelerometer, a gyroscope, a magnetometer, or a similar type of position/orientation sensing device.

As a sensor commonly used in the electronic device, the optical sensor may include one or more optical components. In embodiments of this application, the optical component is configured to emit or monitor an optical signal in a specified wavelength range.

Some optical components may include one or more light emitting elements. An optical device including a light emitting element may also be referred to as a light emitter in embodiments of this application.

The light emitting element is defined as an element that can emit an optical signal. For example, the light emitting element may include but is not limited to a light-emitting diode (light-emitting diode, LED), a micro light-emitting diode (micro light-emitting diode), a laser (Laser), a mini light-emitting diode (mini light-emitting diode), and the like. The optical signal may include but is not limited to visible light (visible light), infrared ray (infrared ray), ultraviolet light (ultraviolet light), and the like.

Some optical components may include one or more optical receiving elements. An optical device including an optical receiving element may also be referred to as an optical receiver in embodiments of this application.

The optical receiving element may be configured to monitor an optical signal in a specified wavelength range. For example, the light receiving element may include but is not limited to a photoelectric diode (photoelectric diode, PD), a charge-coupled device (charge-coupled device, CCD), and the like.

The processor of the electronic device may process the optical signal detected by the optical sensor, to implement some functions.

A process in which the electronic device implements some functions by using the optical signal detected by the optical sensor is as follows: The light emitter emits the optical signal; the optical signal is transmitted through the enclosure structure and is incident to a target object; and the optical signal that is incident to the target object may be transmitted through the enclosure structure and returned to the optical receiver after being absorbed, reflected, or refracted by the target object.

The optical signal that is absorbed, reflected, or refracted by the target object is related to a property of the target object. Therefore, the optical receiver may detect the optical signal related to the target object.

Photoplethysmography (photoplethysmography, PPG) is a detection technology commonly used in the electronic device. The electronic device may detect, based on the PPG through the optical sensor, an optical signal related to vital sign data, to implement a health management function. The vital sign data may include but is not limited to a heart rate, blood pressure, and the like.

The following describes an implementation process of the health management function with reference to specific accompanying drawings.

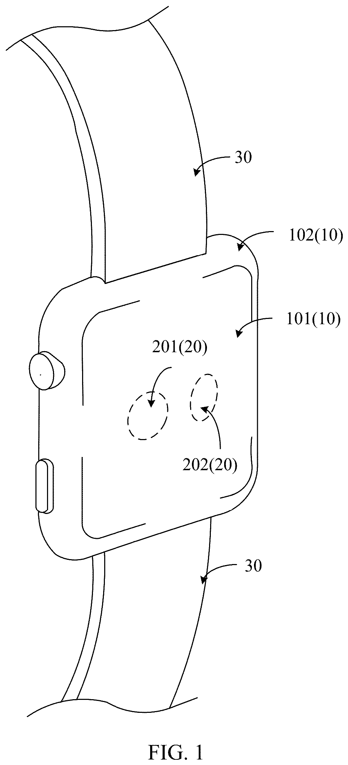

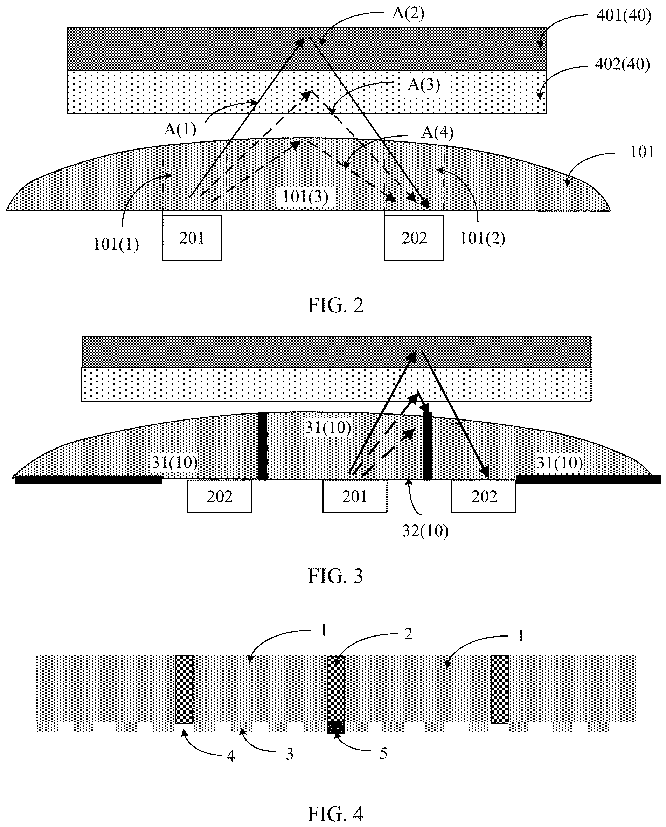

Refer to FIG. 1 and FIG. 2. FIG. 1 is an example of a physical diagram of a wearable device, and FIG. 2 is a diagram of an application scenario of the wearable device.

The wearable device may include an enclosure 10 and an optical sensor 20 disposed inside the enclosure. In some feasible implementations, the wearable device may further include a wrist strap 30. The wrist strap 30 is connected to the enclosure 10, and is configured to sleeve the wearable device on a target object (for example, a wrist).

In some feasible implementations, there may be one or two wrist straps 30. When there is one wrist strap, two opposite ends of the wrist strap are respectively connected to two opposite ends of the enclosure 10, so that the wrist strap 30 and the enclosure 10 form a wearable slot, to be sleeved on the target object. When there are two wrist straps, the two wrist straps 30 are respectively connected to two opposite ends of the enclosure 10, and ends that are of the two wrist straps and that are far away from the enclosure are buckled, so that the wrist straps and a frame form a wearable slot, to be sleeved on the target object.

The enclosure 10 may include two enclosure structures: a glass bottom plate 101 and a frame 102.

The frame 102 is disposed around the glass bottom plate 101. The glass bottom plate 101 and the frame 102 form a cavity configured to accommodate the optical sensor 20.

The optical sensor 20 may include at least one light emitter 201 configured to emit an optical signal and at least one optical receiver 202 configured to receive an optical signal.

As shown in FIG. 2, during wearing, an outer surface of the glass bottom plate 101 of the wearable device is located on a side close to a human body 40, and an optical signal A(1) emitted by the light emitter 201 reaches the human body 40 through the glass bottom plate 101(1). After the optical signal is reflected by human blood and tissue 401, a reflected optical signal A(2) is obtained. The reflected optical signal A(2) may be transmitted through the glass bottom plate 101(2) and returned to the optical receiver 202. The optical receiver 202 may record a change of a blood vessel volume in a cardiac periodicity based on different strengths of reflected optical signals, to obtain a pulse waveform, and calculate a heart rate based on the obtained pulse waveform.

Generally, the optical signal detected by the optical receiver 202 may include an effective signal and an interference signal.

The effective signal is defined as an optical signal that is absorbed, reflected, or refracted by the target object, and the effective signal is related to a property of the target object. When being specifically applied to the application scenario in FIG. 2, the effective signal refers to the reflected optical signal A(2) that is reflected by the human blood and tissue 401.

The interference signal may include an optical signal that is not absorbed, reflected, or refracted by the target object. The interference signal is not related to the property of the target object. When being specifically applied to the application scenario in FIG. 2, an ineffective signal includes a reflected optical signal A(3) reflected by skin 402 and an optical signal A(4) propagated inside the glass bottom plate 101(3).

Generally, the enclosure structure is made of a transparent material. A part of the optical signal emitted by the light emitter may be transmitted to the optical receiver through a transition area.

The transition area may be defined as an area between an area in which a projection of the light emitter on the enclosure structure is located and an area in which a projection of the optical receiver on the enclosure structure is located. In this embodiment of this application, the area in which the projection of the light emitter on the enclosure structure is located may also be referred to as an area corresponding to the light emitter in the enclosure structure. The area in which the projection of the optical receiver on the enclosure structure is located may also be referred to as an area corresponding to the optical receiver in the enclosure structure.

The optical signal transmitted through the transition area is a typical interference signal. Existence of the interference signal may decrease accuracy of a monitoring result of the optical receiver.

To improve accuracy of the monitoring result of the optical receiver 202, the enclosure structure of the electronic device is further improved in a related technology. For details, refer to FIG. 3. FIG. 3 is a diagram of an application scenario of an electronic device disclosed in the related technology.

An enclosure structure 10 in FIG. 3 is formed by splicing a plurality of glass plates 31. The glass plates 31 are disposed at positions corresponding to an emitting optical path of a light emitter 201/a receiving optical path of an optical receiver 202. An opaque material 32 is disposed between adjacent glass plates 31. In other words, the opaque material 32 is located in a transition area.

In the related technology disclosed in FIG. 3, the opaque material 32 may block an interference signal to an extent. However, the enclosure structure 10 disclosed in FIG. 3 needs to be formed by splicing the plurality of glass plates 31. The splicing processing manner increases processing difficulty of the enclosure structure 10. In the splicing processing manner, a processing tolerance between the glass plates 31 needs to be controlled. Compared with an integrally formed enclosure structure, the enclosure structure 10 in the related technology disclosed in FIG. 3 may have a problem of high preparation costs, and a splicing part of the enclosure structure 10 may have a reliability risk.

A preparation process of the integrally formed enclosure structure is further disclosed in the related technology.

Specifically, ion exchange is performed on glass with different thicknesses to change glass components of some thicknesses, and then the glass is thinned to obtain glass with a same thickness but different partial components. Finally, because a glass component difference may cause different crystallization tendencies, after heat treatment is performed at a proper temperature, crystallization is performed in some areas, and crystallization is not performed in some areas, to form a composite enclosure structure having a transparent area and an opaque area.

In the foregoing related technology, the opaque area may be used to block an interference signal. However, in the preparation process in the foregoing related technology, glass plates with different thicknesses need to be formed in advance, and subsequently, the glass plates further need to be thinned. The preparation process is complex. In addition, in the related technology, ion exchange needs to be performed, and the ion exchange process takes a long time.

Specifically, the glass plate is partially heated or the glass plate is overall heated but partially heat-shielded, so that a crystallization speed in a heating area 51 of the glass plate is greater than a crystallization speed in a non-heating area of the glass plate.

A transmittance of a crystallized heating area is greater than a transmittance of a crystallized non-heating area.

In the foregoing related technology, a partial heating manner needs to be used, so that the heating area and the non-heating area have different transmittances. A second area generated by the heating area has a small transmittance, so that the second area can block the interference signal to an extent. However, the partial heating processing manner may cause problems such as a warp and a deformation due to uneven heating of the enclosure structure.

In conclusion, there are some disadvantages in performance of the enclosure structure disclosed in the related technology.

To compensate for the disadvantages in the related technology, embodiments of this application disclose an enclosure structure. As shown in FIG. 4 to FIG. 9, the enclosure structure may include a first area 1 and a second area 2. The first area 1 and the second area 2 are of an integrally formed structure. Therefore, the enclosure structure has good mechanical performance. The second area 2 includes glass-ceramic and a metal cluster. The metal cluster is used as a crystal nucleus of the glass-ceramic, and the metal cluster helps form the glass-ceramic, so that the second area 2 may have a large crystallinity. A crystallinity is inversely related to a transmittance. The second area 2 has a large crystallinity, and correspondingly, the second area 2 has a small transmittance. The second area 2 having a small transmittance may block propagation of an interference signal inside the enclosure structure to an extent, to reduce the interference signal.

The following further describes the enclosure structure.

First, a raw material used for the enclosure structure is described. In embodiments of this application, unless otherwise specified, a raw material is the raw material used for the enclosure structure.

In this embodiment of this application, the raw material of the enclosure structure may include a glass substrate.

A component of the glass substrate is not specifically limited in embodiments of this application.

For example, the glass substrate may include but is not limited to at least one of silicate glass, aluminosilicate glass, phosphate glass, aluminophosphate glass, borate glass, and aluminate glass.

For example, the glass substrate may include but is not limited to a Na-Al-Si glass system, a Li-Al-Si glass system, and a Na-Zn-Al-Si glass system.

For example, the glass substrate may include silicon dioxide ($SiO_2$), aluminum trioxide ($Al_2O_3$), zinc oxide (ZnO), lithium oxide ($Li_2O$), sodium oxide ($Na_2O$), potassium oxide ($K_2O$), zirconium oxide ($ZrO_2$), and bismuth oxide ($Sb_2O_3$).

In this embodiment of this application, only several components of the glass substrate are described as examples, and the foregoing components constitute a specific limitation.

In this embodiment of this application, the raw material may further include a photosensitive material. The photosensitive material includes a nucleating metal.

In this embodiment of this application, the photosensitive material is defined as that the nucleating metal that exists in a form of a compound inside the photosensitive material is converted into a metal in an atomic state under an action of an optical signal. The metal in the atomic state may also be referred to as a metal atom in this embodiment of this application.

A relatively stable micro or sub-micro aggregate is formed by metal atoms through a physical or chemical bonding force. The stable micro or sub-micro aggregate may be referred to as a metal cluster in this embodiment of this application. For example, the metal cluster may include a Cu cluster, an Ag cluster, and an Au cluster.

In this embodiment of this application, the nucleating metal is defined as a metal that has good reduction performance and that is easy to be precipitated from a compound to form a free atom. For example, the nucleating metal may include but is not limited to copper (Cu), silver (Ag), and gold (Au).

In this embodiment of this application, the raw material further includes the photosensitive material. The photosensitive material may convert, under illumination of the optical signal, the nucleating metal that exists in the form of a compound inside the photosensitive material into the nucleating metal in the atomic state, and the nucleating metal in the atomic state may be aggregated to form the metal cluster. In this way, a partial exposure manner may be used, so that the nucleating metal that exists in the form of a compound in an exposed area is reduced to the nucleating metal in the atomic state, to form the metal cluster. In a subsequent overall heat treatment process, a part having the metal cluster is more easily crystallized to form the second area having a small transmittance, to obtain the first area and the second area that are integrally formed and that have different transmittances. In a process of generating the enclosure structure disclosed in this implementation, an overall heat treatment manner may be used, so that a warp between the first area and the second area is small.

In a feasible implementation, the photosensitive material may include a photosensitive compound.

The photosensitive compound is defined to be capable of absorbing the optical signal and releasing an electron ($e^-$) under the action of the optical signal, where $e^-$ may be combined with the nucleating metal that exists in the form of a compound, so that the nucleating metal that exists in the form of a compound is restored to a metal atom in a free state.

For example, the photosensitive compound may include but is not limited to cerium oxide ($CeO_2$) and cerium trioxide ($Ce_2O_3$).

In a feasible implementation, the photosensitive material may include an anion, and the anion and the nucleating metal may form a light sensitive compound.

The light sensitive compound is defined as a compound from which a metal atom can be precipitated under the action of the optical signal.

For example, the light sensitive compound may be but is not limited to silver bromide (AgBr), silver chloride (AgCl), and silver iodide (AgBr).

It should be noted that, in this embodiment of this application, only several light sensitive compounds are described as examples, and the light sensitive compounds do not constitute a specific limitation.

The following uses an example in which the light sensitive compound includes AgBr to describe generation of the Ag cluster.

AgBr can generate silver atoms (Ag) and bromide vapor ($Br_2$) under the action of the optical signal. $Br_2$ exists in a form of gas, and $Br_2$ that exists in the form of gas is easy to escape, leaving Ag. Ag may form the Ag cluster through a physical or chemical bonding force.

It should be noted that, in this embodiment of this application, only several photosensitive materials are described as examples, and the foregoing photosensitive materials do not constitute a specific limitation. Any material from which a nucleating metal atom can be precipitated under the action of the optical signal may be used as a photosensitive material and applied to embodiments of this application.

In a process from the raw material to the enclosure structure, the raw material needs to undergo processes such as melting, partial exposure, and crystallization/heat treatment. The processes such as melting, partial exposure, and crystallization/heat treatment are further described in a subsequent preparation method.

For ease of description, a structure before the enclosure structure is formed is referred to as a glass plate/raw material. The glass plate/raw material is divided into the exposed area and an unexposed area. The unexposed area may be finally converted into the first area of the enclosure structure, and the exposed area may be finally converted into the second area of the enclosure structure.

In a feasible implementation, all nucleating metals in the unexposed area exist in the form of a compound. In other words, the unexposed area includes no metal cluster.

In the implementation in which all the nucleating metals in the unexposed area exist in the form of a compound, if the raw material includes no compound nucleating agent (an oxide, a fluoride, and the like, which apply to the following scenarios), in the crystallization heat treatment process, the unexposed area may not be crystallized. The unexposed area still exists in a form of common glass. In other words, the first area includes the common glass. The exposed area may be crystallized by using the metal cluster as a crystal nucleus to generate the second area, and the second area includes glass-ceramic and the metal cluster.

In the implementation in which all the nucleating metals in the unexposed area exist in the form of a compound, if the raw material includes a compound nucleating agent, in the crystallization heat treatment process, the unexposed area may be crystallized to form the first area. In this case, the first area includes glass-ceramic. The exposed area may be crystallized to generate the second area, and the second area includes the glass-ceramic and the metal cluster.

In a feasible implementation, the nucleating metal in the unexposed area is affected by some inevitable factors. As a result, a nucleating metal atom is precipitated from a part of the nucleating metal in the unexposed area, and therefore, the unexposed area includes the metal cluster.

In the implementation in which the unexposed area includes the metal cluster, in the crystallization heat treatment process, the unexposed area may be crystallized by using the metal cluster as a crystal nucleus, to form the first area. The first area may include glass-ceramic and the metal cluster. The exposed area may be crystallized to generate the second area, and the second area includes the glass-ceramic and the metal cluster.

In the implementation in which the unexposed area includes the metal cluster, the optical signal helps form the metal cluster. Therefore, a density of the metal cluster in the exposed area is greater than a density of the metal cluster in the unexposed area. A crystallinity is positively correlated with a density of a metal cluster. Therefore, a crystallinity of the exposed area is greater than a crystallinity of the unexposed area. A transmittance of the second area formed by the exposed area is less than a transmittance of the first area formed by the unexposed area. The second area having a smaller transmittance may block propagation of the interference optical signal to an extent. The first area has a larger transmittance, to ensure a small loss in a process of transmitting an effective optical signal and an emitted optical signal through the first area.

In a feasible implementation, the raw material may include a halogen element. In the forming process of the enclosure structure, a melting process needs to be performed.

In this embodiment of this application, melting is performed in a high-temperature environment, and the raw material is converted to be in a melted state in the high-temperature environment, so that the raw material is evenly mixed.

In this implementation, the raw material may include the halogen element. The halogen element in the high-temperature environment may provide an acid/oxidized gas atmosphere, to prevent the nucleating metal in the raw material from being precipitated in a form of an atom, so as to avoid forming the metal cluster in the melting process. A quantity/density of metal clusters in the unexposed area can be reduced, and the crystallinity of the unexposed area can be reduced, so that the first area formed by the unexposed area has a large transmittance, to ensure a small loss in the process of transmitting the effective optical signal and the emitted optical signal through the first area.

So far, the descriptions of the raw material of the enclosure structure are provided.

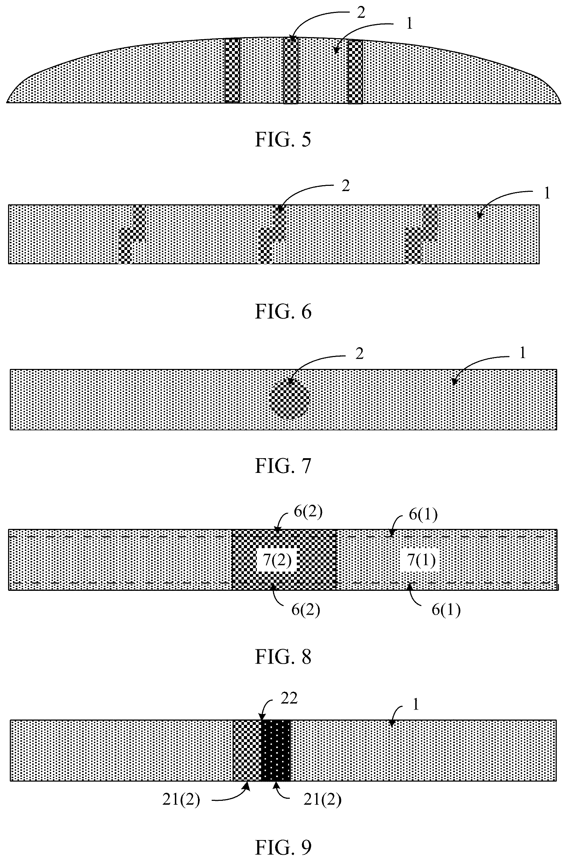

The following describes a structure of the enclosure structure. A shape of the enclosure structure is not specifically limited in embodiments of this application. For example, as shown in FIG. 4, in a feasible implementation, the enclosure structure may have a planar structure. As shown in FIG. 5, in a feasible implementation, the enclosure structure may have a curved surface structure.

It should be noted that, in FIG. 4 and FIG. 5, only two structures of the enclosure structure are described as examples, and the foregoing structures do not constitute a specific limitation. In an actual application process, the structure of the enclosure structure may be but is not limited to the foregoing two manners.

Still refer to FIG. 4 and FIG. 5. The enclosure structure may include the first area 1 and the second area 2. The first area 1 and the second area 2 are integrally formed, so that a process interface for glue bonding, splicing, and fusion splicing is not included between the first area 1 and the second area 2. In this way, the enclosure structure has better integration and mechanical performance.

In this embodiment of this application, the first area 1 penetrates the enclosure structure, so that in a process in which the emitted optical signal/the effective optical signal is propagated on two sides of the enclosure structure, the emitted optical signal/the effective optical signal can be transmitted only through the first area 1, and a loss of the emitted optical signal/the effective optical signal is small.

A shape of the first area 1 is not specifically limited in embodiments of this application.

For example, as shown in FIG. 4 and FIG. 5, the first area 1 may be in a column shape.

For example, as shown in FIG. 6, the first area 1 may be in a step shape.

For example, as shown in FIG. 7, the first area 1 may be in a spherical shape.

It should be noted that, in FIG. 4, FIG. 5, FIG. 6, and FIG. 7, only several shapes of the first area are described as examples, and the shapes of the first area do not constitute a specific limitation. In an actual application process, the shape of the first area may be designed based on an actual requirement. This is not excessively limited in embodiments of this application.

A quantity of first areas is not specifically limited in embodiments of this application. For example, the quantity of first areas may be but is not limited to one, two, three, four, or five.

As described above, in some feasible implementations, the first area 1 may include the common glass. In some feasible implementations, the first area 1 may alternatively include the glass-ceramic.

In the implementations in which the first area includes the glass-ceramic, the first area may include the metal cluster.

In the implementations in which the first area includes the metal cluster, the density of the metal cluster in the first area is less than the density of the metal cluster in the second area. A crystallinity of the first area is less than the crystallinity of the second area. The first area has a large transmittance, so that a loss in the process of transmitting the emitted optical signal/the effective optical signal through the first area is small.

In this embodiment of this application, the enclosure structure further includes at least one second area. The second area has a small transmittance, and is used to prevent the interference signal from being propagated inside the enclosure structure.

Still refer to FIG. 4, FIG. 5, and FIG. 6. In a feasible implementation, the second area 2 may penetrate the enclosure structure, so that the second area can block a large quantity of interference signals.

In the implementation in which the second area penetrates the enclosure structure, the second area 2 is disposed between adjacent first areas 1, and the second area has a small transmittance, so that the second area can prevent optical signals from crosstalk between different first areas, thereby blocking the interference signal.

In the implementation in which the second area 2 penetrates the enclosure structure, a shape 1 of the second area is not specifically limited in embodiments of this application.

For example, as shown in FIG. 4 and FIG. 5, in a feasible implementation, the second area may be in a column shape.

For example, as shown in FIG. 6, in a feasible implementation, the second area may be in a step shape.

Still refer to FIG. 7. In a feasible implementation, the second area 2 may be disposed inside the first area 1. In other words, the second area 2 does not penetrate the enclosure structure/the second area 2 is wrapped by the first area 1.

In the implementation in which the second area is disposed inside the first area, a shape of the second area is not specifically limited in embodiments of this application.

For example, as shown in FIG. 7, in a feasible implementation, the second area may be in a spherical shape. Because the first area 1 and the second area 2 have different transmittances, refraction occurs when the interference signal is propagated to a large contact interface between the second area and the first area, to block propagation of the interference signal. A larger contact interface between the second area and the first area indicates a greater blocking effect on the interference signal. The spherical second area has a larger contact interface with the first area, and therefore, the enclosure structure including the spherical second area may have a greater blocking effect on the interference signal.

It should be noted that, in FIG. 4, FIG. 5, FIG. 6, and FIG. 7, several shapes of the second area are described as examples, and the shapes of the second area do not constitute a specific limitation. In an actual application process, the shape of the second area may be designed based on a requirement. This is not excessively limited in this application.

A quantity of second areas is not specifically limited in embodiments of this application. For example, the quantity of second areas may be but is not limited to one, two, three, four, or five.

In a feasible implementation, in an implementation in which the enclosure structure includes a plurality of second areas, any two second areas may have a same transmittance.

In a feasible implementation, in an implementation in which the enclosure structure includes a plurality of second areas, any two second areas may have different transmittances.

As shown in FIG. 8, in a feasible implementation, the enclosure structure includes a compressive stress layer 6 and a tensile stress layer 7. The compressive stress layer 6 is disposed on a surface of the tensile stress layer 7.

The enclosure structure disclosed in this implementation includes the compressive stress layer and the tensile stress layer, and the compressive stress layer is disposed on the surface of the tensile stress layer. To be specific, the compressive stress layer located on an outer surface is subject to compressive stress, and the tensile stress layer located on an inner surface is subject to tensile stress. Existence of the compressive stress layer can block/eliminate generation and extension of a micro-print on the surface of the enclosure structure, to improve mechanical performance of the enclosure structure.

As shown in FIG. 9, to further improve the blocking effect of the enclosure structure on the interference signal, in a feasible implementation, the second area 2 may include at least two sub-areas 21 in contact with each other, and two adjacent sub-areas 21 have different transmittances.

In this implementation, two adjacent sub-areas 21 have different transmittances, and a refraction/reflection interface 22 may be formed between the two sub-areas 21. When the interference signal is propagated to the refraction/reflection interface 22, refraction/reflection occurs, so that an interference signal transmitted through the second area is reduced, to block the interference signal.

A quantity of sub-areas 21 included in each second area is not specifically limited in embodiments of this application. For example, the quantity of sub-areas included in each second area may be but is not limited to one, two, three, four, or five.

A shape of the sub-area 21 is not specifically limited in embodiments of this application. For example, the shape of the sub-area may be but is not limited to a column shape, a step shape, or a spherical shape.

A larger width of the second area indicates a greater blocking effect of the second area on the interference signal. To ensure that the enclosure structure has a greater blocking effect on the interference signal, in a feasible implementation, the width of the second area is greater than or equal to a specified value.

The specified value is not specifically limited in embodiments of this application. For example, the specified value may be 1 $\mu$m or 2 $\mu$m.

Still refer to FIG. 4. In a feasible implementation, a protrusion 3 and/or a recess 4 may be formed on a surface of the enclosure structure.

A shape and a size of the protrusion or the recess are not specifically limited in embodiments of this application, and the shape and the size of the protrusion or the recess may be set based on a requirement.

In a feasible implementation, the protrusion 3/the recess 4 may cover the entire surface of the enclosure structure. In a feasible implementation, the protrusion 3/the recess 4 may cover a part of the surface of the enclosure structure.

For example, in a feasible implementation, the protrusion 3/the recess 4 may cover only a surface of the first area.

For example, in a feasible implementation, the protrusion 3/the recess 4 may cover only a surface of the second area.

For example, in a feasible implementation, the protrusion 3/the recess 4 may cover surfaces of the first area and the second area.

Still refer to FIG. 4. To block more interference signals, in the implementation in which the second area penetrates the enclosure structure, a light blocking layer 5 may be disposed in a recess on the surface of the second area.

In this embodiment of this application, the light blocking layer 5 is defined as a material layer whose transmittance is less than the transmittance of the second area, and may be but is not limited to a material layer including light blocking ink or polyvinyl chloride (polyvinyl chloride).

In this implementation, the light blocking layer 5 is disposed in the recess on the surface of the second area. The light blocking layer 5 and the second area 2 are included between adjacent first areas. Because the transmittance of the light blocking layer 5 is less than the transmittance of the second area, the light blocking layer 5 can block a large quantity of interference signals. Therefore, the enclosure structure disclosed in this implementation can block a large quantity of interference signals.

In the implementation of forming the protrusion/recess on the surface of the enclosure structure, in a feasible implementation, the protrusion and the recess form a Fresnel pattern.

In this embodiment of this application, the Fresnel (Fresnel) pattern is defined as including a series of sawtooth recesses on a surface and an elliptical arc in a central part. Each recess has a different angle from an adjacent recess, but each recess may concentrate the optical signal at one place to form a central focus.

In this implementation, the Fresnel pattern formed by the protrusion/recess on the surface of the enclosure structure may play a focusing role. The Fresnel pattern may be designed to make the central focus formed on the Fresnel pattern fall on an optical detector, to improve a signal-to-noise ratio of the effective optical signal.

The Fresnel pattern is designed on the surface of the enclosure structure, so that the Fresnel pattern can be implemented without using an additional polyethylene glycol terephthalate (polyethylene glycol terephthalate, PET) film, and a stacking size of the enclosure structure can be reduced.

In this implementation, the Fresnel pattern is formed by the protrusion/recess on the surface of the enclosure structure, and the Fresnel pattern and the first area/second area are integrally formed. In this way, a process interface for glue bonding, splicing, or fusion splicing is not included between the first area/second area and the Fresnel pattern. In this way, the enclosure structure has better integration and better mechanical performance.

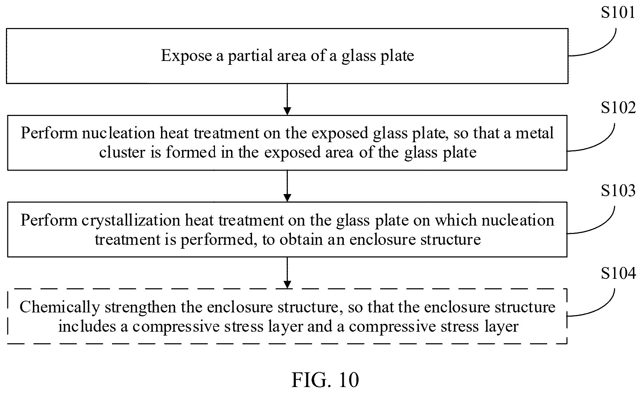

An embodiment of this application further discloses an enclosure structure preparation method. As shown in FIG. 10, the preparation method may include the following steps.

S101: Expose a partial area of a glass plate.

In this embodiment of this application, a raw material used for the glass plate includes a photosensitive material, the photosensitive material includes a nucleating metal, the photosensitive material converts the nucleating metal that exists in a form of a compound inside the photosensitive material into a nucleating metal in an atomic state under an action of an optical signal, and the nucleating metal in the atomic state is used to form a metal cluster.

In a feasible implementation, the raw material may be melted to obtain the glass plate. A common melting manner in the field may be used. This is not specifically limited in embodiments of this application.

For example, processing such as continuous melting, pulling down, casting, molding, and cutting may be sequentially performed on the raw material. Finally, the glass plate having a required size is obtained.

There are a plurality of implementations for partially exposing the glass plate.

In a feasible implementation, the glass plate may be partially exposed through in an optical signal illumination manner.

A process in which the glass plate is partially exposed in the optical signal illumination manner may be: disposing a mask reticle (mask reticle) on a side of the glass plate, where the mask reticle has a transparent window; and illuminating, by the optical signal, the partial area of the glass plate through the window of the mask reticle. In this way, partial exposure of the glass plate is implemented.

In this implementation, partial exposure of the glass plate is implemented by using the mask reticle. A shape/size of the finally obtained second area is a shape/size of the window of the mask reticle. The shape/size of the second area may be flexibly configured by using mask reticles with windows having different shapes/sizes.

In a feasible implementation, the partial area of the glass plate may be illuminated through a laser. A specific implementation process is as follows: A size and a shape of an exposed area may be controlled by controlling a laser path. In this process, no assistance of the mask reticle is required, so that costs of an enclosure structure may be reduced to an extent.

In this embodiment of this application, only two implementations of partial exposure of the glass plate are described as examples, and the foregoing implementations do not constitute a specific limitation.

A band of the optical signal used in the partial exposure phase is not specifically limited in embodiments of this application. For example, the band of the optical signal may be 390 nm to 780 nm, greater than 780 nm, or less than 390 nm.

Intensity of the optical signal is not specifically limited in embodiments of this application, and the intensity of the optical signal may be selected based on a requirement.

Generally, the intensity of the optical signal may be represented by an energy flow density (energy flow density) constant, and an energy flow density is defined as energy or power generated by an optical signal in a unit space range.

In a feasible implementation, the energy flow density of the optical signal is less than or equal to a damage threshold (damage threshold) of the glass plate, so that an internal structure of the exposed area is not damaged in the partial exposure phase.

Exposure time is not specifically limited in embodiments of this application, and appropriate exposure time may be selected based on a requirement. In a specific range, a quantity of metal atoms in the exposed area is positively correlated with the exposure time, and the quantity of metal atoms in the exposed area is inversely correlated with a transmittance of the finally generated second area. To enable the second area to have a small transmittance, an implementation of extending the exposure time may be used.

The shape and the size of the exposed area are not specifically limited in embodiments of this application. In the implementation in which partial exposure is implemented by using the mask reticle, the shape/size of the exposed area may be adjusted by adjusting the shape/size of the window of the mask reticle.

In the implementation in which partial exposure is implemented through the laser, the shape/size of the exposed area may be adjusted by adjusting the laser path.

In a feasible implementation, a patterned exposed area may be implemented by selecting an appropriate laser (time, intensity, a light spot size of the laser, or the band of the optical signal).

For the photosensitive material, refer to the foregoing descriptions of the photosensitive material. Details are not described herein again.

S102: Perform nucleation heat treatment on the exposed glass plate, so that the metal cluster is formed in the exposed area of the glass plate.

In this embodiment of this application, the nucleation heat treatment phase includes a metal cluster growth phase. The nucleation heat treatment phase may be referred to as a nucleation phase for short.

A nucleation heat treatment temperature is not specifically limited in embodiments of this application. For example, the nucleation heat treatment temperature may be 480°C, 490°C, 500°C, 510°C, 520°C, or 530°C.

Thermal insulation time of the nucleation heat treatment is not specifically limited in embodiments of this application. For example, the thermal insulation time of the nucleation heat treatment may be 0.5 h, 1 h, 1.5 h, 3 h, 4 h, or 8 h.

In a feasible implementation, in the nucleation heat treatment process, the metal cluster may not be formed in an unexposed area.

In a feasible implementation, in the nucleation heat treatment process, the metal cluster may be formed in an unexposed area.

In the implementation in which the metal cluster is formed in the unexposed area, because the optical signal helps form the metal cluster, a density of metal atoms in the exposed area is greater than a density of metal atoms in the unexposed area.

The following uses an example in which the photosensitive material includes $CeO_2$ , $Ce_2O_3$ , and $Ag_2O$ to describe the process of forming the metal.

Valences of cerium in $CeO_2$ and $Ce_2O_3$ is a valence of +4 and a valence of +3. Cerium having a valence of +4 may be represented as $Ce^{4+}$ . Cerium having a valence of +3 may be represented as $Ce^{3+}$ . $Ce^{3+}$ can produce strong absorption of ultraviolet light. After absorbing the ultraviolet light, $Ce^{3+}$ releases $e^-$. $e^-$ can be adsorbed nearby $Ce^{4+}$ .

In the nucleation heat treatment process, silver ($Ag^+$) in $Ag_2O$ can be diffused and combined with $e^-$ nearby $Ce^{4+}$, to convert $Ag^+$ into silver (Ag) into an atomic state.

When the temperature rises further, the Ag atom continues to absorb $Ag^+$ and $e^-$ , and Ag may form a stable Ag cluster through a physical or chemical bonding force.

S103: Perform crystallization heat treatment on the glass plate on which nucleation treatment is performed, to obtain the enclosure structure.

In this embodiment of this application, the enclosure structure includes a first area and a second area, the second area is obtained by crystallizing the exposed area of the glass plate, the first area is obtained by crystallizing the unexposed area of the glass plate, and the second area includes glass-ceramic and the metal cluster.

In this embodiment of this application, the crystallization heat treatment phase is a glass-ceramic growth phase. In this embodiment of this application, the crystallization heat treatment phase may be referred to as a crystallization phase for short.

In an implementation in which all nucleating metals in the unexposed area exist in the form of a compound after the nucleation phase, if the raw material includes no compound nucleating agent, the unexposed area still exists in a form of common glass. In other words, the first area includes the common glass. The exposed area may be crystallized by using the metal cluster as a crystal nucleus to generate the second area, and the second area includes the glass-ceramic and the metal cluster.

In an implementation in which all nucleating metals in the unexposed area exist in the form of a compound after the nucleation phase, if the raw material includes a nucleating agent, in the crystallization phase, the unexposed area may be crystallized by using the nucleating agent as a crystal nucleus to form the first area, and the first area includes the glass-ceramic. The exposed area may be crystallized to generate the second area, and the second area includes the glass-ceramic and the metal cluster.

In the implementation in which the unexposed area includes the metal cluster after the nucleation phase, in the crystallization phase, the unexposed area may be crystallized to form the first area, and the first area includes the glass-ceramic and the metal cluster. The exposed area may be crystallized to generate the second area, and the second area includes the glass-ceramic and the metal cluster.

The optical signal helps form the metal cluster. Therefore, a density of the metal cluster in the exposed area is greater than a density of the metal cluster in the unexposed area. A crystallinity is positively correlated with a density of a metal cluster. Therefore, a crystallinity of the exposed area is greater than a crystallinity of the unexposed area. A transmittance of the second area formed by the exposed area is less than a transmittance of the first area formed by the unexposed area.

A treatment temperature in the crystallization phase is not specifically limited in embodiments of this application. For example, a heat treatment temperature in the crystallization phase may be 580°C, 590°C, 600°C, 610°C, 620°C, or 630°C.

Thermal insulation time in the crystallization phase is not specifically limited in embodiments of this application. For example, the thermal insulation time in the crystallization phase may be 0.5 h, 1 h, 1.5 h, 3 h, 4 h, 8 h.

In this implementation, the glass plate is used to form the enclosure structure, and the glass plate includes the photosensitive material. Under the action of the optical signal, the nucleating metal that exists in the form of a compound inside the photosensitive material is converted into the nucleating metal in the atomic state, and the nucleating metal in the atomic state may be aggregated to form the metal cluster. In this way, a manner of partial exposure using the optical signal may be used, so that the metal cluster is formed in the exposed area. In a subsequent overall heat treatment process, the exposed area having the metal cluster is easily crystallized to form the second area having a small transmittance, and the second area having a small transmittance may block propagation of an interference signal inside the enclosure structure to an extent, to reduce the interference signal. According to the preparation method disclosed in this implementation, the first area having a small/zero crystallinity and the second area having a large crystallinity may be obtained in the overall heat treatment manner, and a warp between the first area and the second area in the prepared glass plate is small.

In an implementation, the preparation method further includes the following step.

S104: Chemically strengthen the enclosure structure, so that the enclosure structure includes a compressive stress layer and a compressive stress layer.

The compressive stress layer is disposed on a surface of the tensile stress layer.

The chemical strengthening manner commonly used in the field is used, so that the enclosure structure may include the compressive stress layer and the compressive stress layer. In a feasible implementation, the enclosure structure may be chemically strengthened in an ion exchange manner.

For example, the enclosure structure may be placed in molten potassium nitrate or a potassium nitrate solution/a molten mixture of sodium nitrate and sodium nitrate or a mixed solution of potassium nitrate and sodium nitrate, where ions are exchanged. Sodium ions ($Na^+$) on a surface of the enclosure structure may be exchanged with potassium ions ($K^+$) in the potassium nitrate. In this way, $Na^+$ on the surface of the enclosure structure is replaced by $K^+$ having a larger ion radius, to implement chemical strengthening.

There is a volume difference between the surface of the enclosure structure before chemical strengthening and the surface of the enclosure structure after chemical strengthening. The volume difference forms the compressive stress layer within a specific depth range of the enclosure structure. Existence of the compressive stress layer can block/-eliminate generation and extension of a micro-print on the surface of the enclosure structure, to improve mechanical performance of the enclosure structure.

A heat treatment temperature in the ion exchange process is not specifically limited in embodiments of this application. For example, the heat treatment temperature in the ion exchange process may be 350°C or 400°C.

Heat treatment time of the ion exchange process is not specifically limited in embodiments of this application. The heat treatment time of the ion exchange process is 0.5 h, 1 h, 1.5 h, 3 h, 4 h, or 8 h.

In a feasible implementation, the second area including a plurality of sub-areas may be formed through a plurality of times of exposure and heat treatment, and two adjacent sub-areas have different transmittances, so that a refraction/reflection interface may be formed between the two sub-areas. When the interference signal is propagated to the refraction/reflection interface, refraction/reflection occurs, so that an interference signal transmitted through the second area is reduced.

In a feasible implementation, a protrusion/recess may be formed on the surface of the enclosure structure.

The implementation of forming the protrusion/recess is not specifically limited in embodiments of this application. For example, in a feasible implementation, the protrusion/recess may be formed on the surface of the enclosure structure in a dry etching manner. In a feasible implementation, the protrusion/recess may be formed on the surface of the enclosure structure in a wet etching manner. An etching solution used in the wet etching manner may include but is not limited to hydrofluoric acid (HF).

The following describes preparation disclosed in embodiments of this application with reference to specific examples.

Embodiment 1

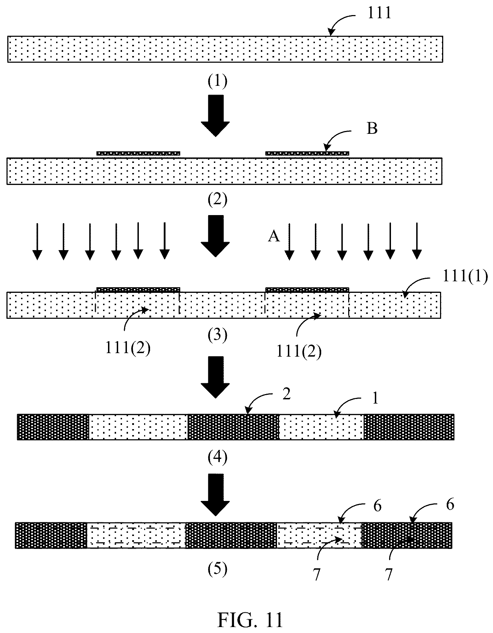

(1) Melting: Refer to (1) in FIG. 11. The raw material is measured (with a mass fraction wt): $SiO_2$ (77.18%), $Al_2O_3$ (5%), ZnO (1.5%), $Li_2CO_3$ (9%), $Na_2CO_3$ (2.5%), $K_2CO_3$ (4%), $ZrO_2$ (0.5%), $Sb_2O_3$ (0.2%), $Ag_2O$ (0.1%), and $CeO_2$ (0.02%). The raw material is melted, where the melting may include a processing manner like continuous melting, pulling down, casting, molding, or cutting, to obtain a glass plate 111 having an appropriate size.

(2) As shown in (2) in FIG. 11, a mask reticle B is disposed on a side of the glass plate 111.

(3) Partial exposure: The glass plate 111 is partially exposed by using ultraviolet light A in a band of 290 nm to 330 nm and the mask reticle B. As shown in (3) in FIG. 11, an exposed area 111(1) and an unexposed area 111(2) are formed on the glass plate. Metal atoms (not shown in the figure) are precipitated in the exposed area 111(1).

(4) Nucleation: The glass plate obtained in (3) is heated to about 500°C for heat preservation, and then annealed. The metal atoms in the exposed area 111(1) are combined into a metal cluster.

(5) Crystallization: The glass plate obtained in (4) is heated to about 675°C for heat preservation, and then cooled in a furnace. The exposed area 111(1) is crystallized by using the metal cluster as a crystal nucleus, and the unexposed area 111(2) does not change. For a structure of an obtained enclosure structure, refer to (4) in FIG. 11. The enclosure structure may include a first area 1 and a second area 2.

(6) The enclosure structure is polished.

(7) The enclosure structure is chemically strengthened at 450°C in molten potassium nitrate or a potassium nitrate solution. For a structure of the chemically strengthened enclosure structure, refer to (5) in FIG. 11. The chemically strengthened enclosure structure includes a compressive stress layer 6 and a tensile stress layer 7.

(8) Processing such as coating is performed on the chemically strengthened enclosure structure.

Embodiment 2

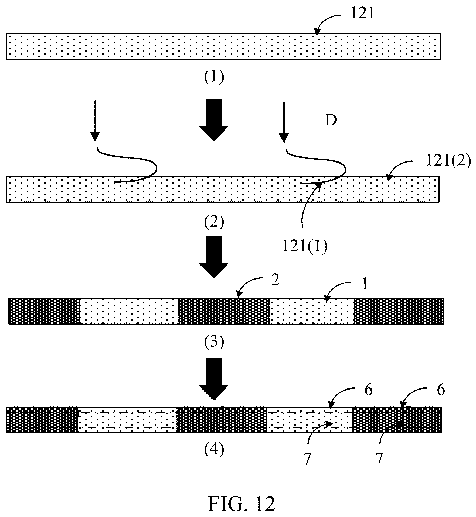

(1) Melting: Refer to (1) in FIG. 12. Components of the raw material are measured (wt): $SiO_2$ (76%), $Al_2O_3$ (5%), ZnO (1.7%), $Li_2CO_3$ (9%), $Na_2CO_3$ (3.5%), $K_2CO_3$ (4%), $ZrO_2$ (0.5%), $Sb_2O_3$ (0.2%), $Ag_2O$ (0.08%), and $CeO_2$ (0.02%). The raw material is melted to obtain a glass plate 121.

(2) Partial exposure: As shown in (2) in FIG. 12, a part of the glass plate 121 is illuminated through a laser D, and an exposed area 121(1) and an unexposed area 121(2) is formed on the glass plate. Metal atoms (not shown in the figure) are precipitated in the exposed area 121(1).

(3) Nucleation: The glass plate obtained in (2) is heated to about 500°C for heat preservation, and then annealed. The metal atoms in the exposed area 121(1) are combined into a metal cluster.

(4) Crystallization: The glass plate obtained in (3) is heated to about 675°C for heat preservation, and then cooled in a furnace. The exposed area 121(1) is crystallized by using the metal cluster as a crystal nucleus, and the unexposed area 121(2) does not change. In this way, an enclosure structure is obtained. For a structure of the enclosure structure, refer to (3) in FIG. 12. The enclosure structure may include a first area 1 and a second area 2.

(5) The enclosure structure is polished.

(6) The enclosure structure is chemically strengthened at 360°C in a mixture of 90% molten potassium nitrate and 10% molten sodium nitrate, to obtain a chemically strengthened enclosure structure. For a structure of the chemically strengthened enclosure structure, refer to (4) in FIG. 12. The chemically strengthened enclosure structure includes a compressive stress layer 6 and a tensile stress layer 7.

Embodiment 3

(1) Melting: Refer to (1) in FIG. 12. Components of the raw material are measured (wt): $SiO_2$ (70%), $Al_2O_3$ (10.5%), ZnO (1%), $Li_2CO_3$ (9%), $Na_2CO_3$ (3.5%), NaF (1%), $K_2CO_3$ (2%), $ZrO_2$ (1%), AgCl (1%), and $CeO_2$ (1%). The raw material is melted to obtain a glass plate 121.

(2) Partial exposure: As shown in (2) in FIG. 12, a part of the glass plate 121 is illuminated through a laser D, and an exposed area 121(1) and an unexposed area 121(2) is formed on the glass plate. Metal atoms (not shown in the figure) are precipitated in the exposed area 121(1).

(3) Nucleation: The glass plate obtained in (2) is heated to about 500°C for heat preservation, and then annealed. The metal atoms in the exposed area 121(1) are combined into a metal cluster.

(4) Crystallization: The glass plate obtained in (3) is heated to about 675°C for heat preservation, and then cooled in a furnace. The exposed area 121(1) is crystallized by using the metal cluster as a crystal nucleus, and the unexposed area 121(2) does not change. In this way, an enclosure structure is obtained. For a structure of the enclosure structure, refer to (3) in FIG. 12. The enclosure structure may include a first area 1 and a second area 2.

(5) The enclosure structure is chemically strengthened at 350°C in a mixture of 80% molten potassium nitrate and 20% molten sodium nitrate, to obtain a chemically strengthened enclosure structure. For a structure of the enclosure structure, refer to (4) in FIG. 12. The chemically strengthened enclosure structure includes a compressive stress layer and a tensile stress layer.

(6) Processing such as coating is performed on the enclosure structure obtained in (5).

The enclosure structure in embodiments of this application may be prepared according to the method in the following embodiments of this application, or may be prepared according to another method. The preparation method in embodiments of this application is merely one or more methods for preparing the enclosure structure in this application, and should not be construed as a limitation on the enclosure structure disclosed in embodiments of this application.

An embodiment of this application further discloses an enclosure, and the enclosure includes at least one enclosure structure disclosed in embodiments of this application.

In a feasible implementation, the plurality of enclosure structures are separate structures, and the plurality of enclosure structures may be connected together in a manner of bonding, fusion splicing, splicing, or the like.

In a feasible implementation, the plurality of enclosure structures may be of an integrated structure.

In a feasible implementation, the enclosure may further include a cover bottom layer, and the cover bottom layer is disposed on a surface of the enclosure structure.

In this embodiment of this application, the cover bottom layer may be obtained by performing light curing or thermal curing on ink that has at least one of a light reflection function and a light absorption function. For example, the cover bottom layer is obtained by performing light curing or thermal curing on black ink or white ink.

In the implementation in which the bottom cover layer is disposed in the enclosure structure, if a second area penetrates the enclosure structure, the bottom cover layer is disposed avoiding a first area of the enclosure structure.

For detailed descriptions of a part of features that are the same in this embodiment and the foregoing embodiments, refer to the foregoing embodiments. Details are not described herein again.

An embodiment of this application further discloses an electronic device. The electronic device may include the enclosure structure disclosed in embodiments of this application, a light emitter, and an optical receiver. The light emitter is disposed on a side of the enclosure structure and is disposed close to a first area. A projection of the light emitter on the enclosure structure coincides with the first area. The light emitter is configured to emit an optical signal to the first area. The optical receiver is disposed on the same side of the enclosure structure as the light emitter and is disposed close to the first area. A projection of the optical receiver on the enclosure structure coincides with the first area. The optical receiver is configured to receive an optical signal (an effective optical signal) that is transmitted through the first area and that is reflected into the first area.

It should be understood that, in this embodiment of this application, that the projection of the light emitter on the enclosure structure coincides with the first area may be understood as that the optical signal emitted by the light emitter may be incident to the first area, and at least partially pass through the first area. Similarly, in this embodiment of this application, that the projection of the optical receiver on the enclosure structure coincides with the first area may be understood as that the optical receiver may receive an optical signal that is emitted by the light emitter and that is reflected into the first area.

In an implementation in which a second area is located inside the first area, the second area is located between the projection of the light emitter on the first area and the projection of the optical receiver on the first area.

In an implementation in which a second area penetrates the enclosure structure, the second area is located between adjacent first areas.

In an implementation in which an inner surface of the enclosure structure includes a Fresnel pattern, in a feasible implementation, a focusing effect may be implemented by using the Fresnel pattern, so that a beam angle of the optical signal emitted by the light emitter is smaller, the optical signal emitted by the light emitter is more focused, and more optical signals can reach a target object.

In a feasible implementation, a focusing effect may be implemented by using a Fresnel pattern, and a beam angle of an effective signal is narrowed, so that the optical receiver can receive more effective signals.

In a feasible implementation, the electronic device may further include a cover bottom layer, and the cover bottom layer is disposed on a surface of the enclosure structure.

In the implementation in which the bottom cover layer is disposed in the enclosure structure, if the second area penetrates the enclosure structure, the bottom cover layer is disposed avoiding the first area of the enclosure structure.

For detailed descriptions of a part of features that are the same in this embodiment and the foregoing embodiments, refer to the foregoing embodiments. Details are not described herein again.

The following further describes the electronic device disclosed in this embodiment of this application with reference to specific data.

Table 1 shows data generated by an electronic device disclosed in a feasible embodiment.

Table 1

| Soluti on | Light source (light emitter ) | PI | Total receive d energy | Light leakage | Skin surface reflecti on | Trans mittan ce of a first area | Trans mittan ce of a secon d area | Refracti ve index of the first area | Refracti ve index of the second area | Width of the first area/μm | Width of the secon d area/μm |
|---|---|---|---|---|---|---|---|---|---|---|---|
| Embo diment 4 | G (green light) | -1.25% | 4.54E-05 | 1.97E-10 | 1.64E-10 | 89 | 30 | 1.515 | 1.515 | 5.2 | 1.1 |
| | R (red light) | -0.58% | 4.88E-04 | 2.03E-09 | 3.74E-09 | 89 | 40 | 1.510 | 1.511 | | |
| | IR (infrare d) | -0.48% | 3.10E-03 | 3.55E-09 | 1.08E-08 | 89 | 60 | 1.505 | 1.505 | | |
| Embo diment 5 | G | -1.29% | 4.31E-05 | 0 | 0 | 89 | 5 | 1.515 | 1.528 | 5.2 | 1.1 |
| | R | -0.57% | 4.74E-04 | 1.27E-10 | 1.78E-10 | 89 | 15 | 1.510 | 1.523 | | |
| | IR | -0.50% | 3.06E-03 | 1.38E-09 | 4.20E-09 | 89 | 45 | 1.505 | 1.517 | | |
| Embo diment 6 | G | -1.13% | 6.30E-05 | 7.21E-10 | 6.14E-10 | 89 | 30 | 1.515 | 1.515 | 5.2 | 0.5 |
| | R | -0.55% | 5.71E-04 | 1.91E-09 | 2.93E-09 | 89 | 40 | 1.510 | 1.511 | | |
| | IR | -0.48% | 3.31E-03 | 4.32E-09 | 6.00E-09 | 89 | 60 | 1.505 | 1.505 | | |
| Comp arative embo diment | G | -0.25% | 2.29E-04 | 1.67E-05 | 3.52E-05 | - | - | - | - | - | - |
| | R | -0.22% | 1.04E-03 | 2.92E-05 | 6.21E-05 | - | - | - | - | - | - |
| | IR | -0.24% | 4.44E-03 | 2.22E-05 | 4.47E-05 | - | - | - | - | - | - |

A PPG signal includes a direct current DC component and an alternating current AC component. The DC component reflects a feature of non-pulsatile tissue, such as epithelial tissue, bone, vein blood, and non-pulsatile arterial blood. The AC component is generated by pulsatile arterial blood. A ratio of an alternating current to a direct current in the PPG signal at a specific wavelength is also referred to as a perfusion index (perfusion index, PI) of the corresponding wavelength.

(1) It can be learned from the light leakage data in Table 1 that the light leakage (IR, R, and G) phenomenon in Embodiment 4, Embodiment 5, and Embodiment 6 is alleviated compared with that in the comparative embodiment.

(2) Through comparison between light leakage data (IR, R, and G) in Embodiment 4 and Embodiment 5, it can be learned that increasing a width of the second area reduces light leakage, and increasing the width of the second area can improve an interference signal blocking effect.

(3) A decrease in the width of the second area causes an increase in light leakage and a decrease in the perfusion index, and can reduce deterioration of power consumption to an extent. Therefore, an appropriate width of the second area may be selected based on a requirement.

(4) An enclosure structure of a same structure is used in Embodiment 4 and Embodiment 5, and a difference lies in that transmittances of second areas are different. Through comparison between the light leakage data (IR, R, and G) in Embodiment 4 and Embodiment 5, it can be found that the transmittance has great impact on the infrared light leakage phenomenon.

(5) Through comparison between the leakage light data (IR, R, and G) and PIs in Embodiment 4, Embodiment 5, and Embodiment 6, it can be learned that the PI is related to a transmittance. A smaller transmittance of the second area indicates a larger PI value (a larger absolute value) of the electronic device.

An "embodiment" or an "implementation" mentioned in this application means that a particular feature, structure, or characteristic described with reference to an embodiment may be included in at least one embodiment of this application. The phrase shown in various locations in the specification not necessarily refers to a same embodiment, and is not an independent or optional embodiment exclusive from another embodiment. It is explicitly and implicitly understood by a person skilled in the art that embodiments described in this application may be combined with another embodiment. In addition, it should be further understood that features, structures, or characteristics described in embodiments of this application, when there is no contradiction between each other, may be randomly combined to form another embodiment without departing from the spirit and scope of the technical solutions of this application.

Finally, it should be noted that the foregoing implementations are merely intended for describing the technical solutions of this application, but not for limiting the technical solutions of this application. Although this application is described in detail with reference to the example implementations, a person of ordinary skill in the art should understand that any modification or equivalent replacement made to the technical solutions of this application should not depart from the spirit and scope of the technical solutions of this application.

**Claims**

1.   An enclosure structure, comprising a first area and a second area, wherein

   the first area and the second area are integrally formed, and a transmittance of the first area is greater than a transmittance of the second area; and
   the second area comprises glass-ceramic and a metal cluster.

2.   The enclosure structure according to claim 1, wherein the first area comprises no metal cluster, or a density of a metal cluster in the first area is less than a density of the metal cluster in the second area.

3.   The enclosure structure according to claim 1 or 2, wherein the metal cluster comprises one or a mixture of clusters in an Ag cluster, a Cu cluster, and an Au cluster.

4.   The enclosure structure according to any one of claims 1 to 3, wherein a raw material used for the enclosure structure comprises a photosensitive material, the photosensitive material comprises a nucleating metal, the photosensitive material converts the nucleating metal that exists in a form of a compound inside the photosensitive material into a nucleating metal in an atomic state under an action of an optical signal, and the nucleating metal in the atomic state is used to form the metal cluster.

5.   The enclosure structure according to claim 4, wherein the photosensitive material further comprises a photosensitive compound, and the photosensitive compound comprises a compound that releases an electron under the action of the optical signal.

6.   The enclosure structure according to claim 5, wherein the photosensitive material further comprises an anion, the anion and the nucleating metal form a light sensitive compound, and the light sensitive compound comprises a compound from which the nucleating metal in the atomic state is precipitated under the action of the optical signal.

7.   The enclosure structure according to any one of claims 1 to 6, wherein the raw material used for the enclosure structure comprises a halogen element.

8.   The enclosure structure according to any one of claims 1 to 7, wherein the first area comprises the glass-ceramic or common glass.

9.   The enclosure structure according to any one of claims 1 to 8, wherein the second area penetrates the enclosure structure.

10.   The enclosure structure according to any one of claims 1 to 9, wherein a surface of the enclosure structure comprises a plane, a curved surface, a protrusion, or a recess.

11.   The enclosure structure according to claim 10, wherein a light blocking layer is disposed in a recess on a surface of the second area, and a transmittance of the light blocking layer is less than the transmittance of the second area.

12.   The enclosure structure according to claim 11, wherein the protrusion and the recess form a Fresnel pattern.

13. The enclosure structure according to any one of claims 1 to 12, wherein the enclosure structure comprises a compressive stress layer and a tensile stress layer; and
the compressive stress layer is disposed on a surface of the tensile stress layer.

14. The enclosure structure according to any one of claims 1 to 13, wherein the second area comprises a plurality of sub-areas in contact with each other, and adjacent sub-areas have different transmittances.

15. The enclosure structure according to any one of claims 1 to 14, wherein a width of the second area is greater than or equal to a specified value.

16. The enclosure structure according to any one of claims 1 to 15, wherein the enclosure structure comprises N second areas, N is greater than or equal to 2, and transmittances of any two second areas are the same, or transmittances of any two second areas are different.

17. An enclosure structure preparation method, comprising:

exposing a partial area of a glass plate, wherein a raw material used for the glass plate comprises a photosensitive material, the photosensitive material comprises a nucleating metal, the photosensitive material converts the nucleating metal that exists in a form of a compound inside the photosensitive material into a nucleating metal in an atomic state under an action of an optical signal, and the nucleating metal in the atomic state is used to form the metal cluster;
performing nucleation heat treatment on the exposed glass plate, so that the metal cluster is formed in the exposed area of the glass plate; and
performing crystallization heat treatment on the glass plate on which nucleation treatment is performed, to obtain an enclosure structure, wherein the enclosure structure comprises a first area and a second area, the second area is obtained by crystallizing the exposed area of the glass plate, the first area is obtained by crystallizing an unexposed area of the glass plate, and the second area comprises glass-ceramic and the metal cluster.

18. The preparation method according to claim 17, wherein the step of exposing the partial area of the glass plate comprises:

disposing a mask reticle on a side of the glass plate, wherein the mask reticle comprises a window; and
illuminating, by an optical signal, the partial area of the glass plate through the window of the mask reticle.

19. The preparation method according to claim 17, wherein the step of exposing the partial area of the glass plate is specifically:
illuminating the partial area of the glass plate through a laser.

20. The preparation method according to any one of claims 17 to 19, wherein an energy flow density of the optical signal used during exposure is less than or equal to a damage threshold of the glass plate.

21. The preparation method according to any one of claims 17 to 20, wherein after the step of performing heat treatment on the exposed glass plate to obtain the enclosure structure, the preparation method further comprises:
chemically strengthening the enclosure structure, so that a compressive stress layer is generated on a surface of the enclosure structure, wherein the compressive stress layer is disposed on a surface of the tensile stress layer.

22. An enclosure, comprising at least one enclosure structure according to any one of claims 1 to 16.

23. An electronic device, comprising a light emitter, an optical receiver, and the enclosure structure according to any one of claims 1 to 16, wherein the enclosure structure comprises a first area and a second area, the light emitter is configured to emit an optical signal that is transmitted through the first area, and the optical receiver is configured to receive the optical signal that is transmitted through the first area; and
the second area is located between a projection of the optical receiver on the first area and a projection of the light emitter on the first area.

24. The electronic device according to claim 23, wherein the electronic device further comprises a cover bottom layer, the cover bottom layer is disposed on an inner surface of the enclosure structure, and the cover bottom layer is disposed avoiding the projection of the optical receiver/the light emitter on the first area.

FIG. 1

A(2)

401(40)

402(40)

A(3)

A(1)

101

101(3)

101(1)

201

202

101(2)

FIG. 2

31(10)

31(10)

31(10)

202

201

202

32(10)

FIG. 3

1

2

1

4

3

5

FIG. 4

FIG. 5

FIG. 6

FIG. 7

FIG. 8

FIG. 9

```
                                                                        S101
┌─────────────────────────────────────────────────────────────┐
│              Expose a partial area of a glass plate           │
└─────────────────────────────────────────────────────────────┘
                              │
                              ▼                                 S102
┌─────────────────────────────────────────────────────────────┐
│ Perform nucleation heat treatment on the exposed glass plate, │
│    so that a metal cluster is formed in the exposed area      │
│                    of the glass plate                         │
└─────────────────────────────────────────────────────────────┘
                              │
                              ▼                                 S103
┌─────────────────────────────────────────────────────────────┐
│ Perform crystallization heat treatment on the glass plate on  │
│   which nucleation treatment is performed, to obtain an       │
│                   enclosure structure                         │
└─────────────────────────────────────────────────────────────┘
                              │
                              ▼                                 S104
┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐
│ Chemically strengthen the enclosure structure, so that the    │
│   enclosure structure includes a compressive stress layer     │
│            and a compressive stress layer                     │
└ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
```

FIG. 10

111

(1)

B

(2)

A

111(1)

111(2)          (3)          111(2)

2          1

(4)

6          6

(5)          7          7

FIG. 11

121

(1)

D

121(2)

(2)

121(1)

2  1

(3)

6  6

(4)

7  7

FIG. 12

## INTERNATIONAL SEARCH REPORT

| International application No. |
| --- |
| **PCT/CN2023/134509** |

**A. CLASSIFICATION OF SUBJECT MATTER**

H05K5/02(2006.01)i

According to International Patent Classification (IPC) or to both national classification and IPC

**B. FIELDS SEARCHED**

Minimum documentation searched (classification system followed by classification symbols)

IPC:H05K,G06F,H01L

Documentation searched other than minimum documentation to the extent that such documents are included in the fields searched

Electronic data base consulted during the international search (name of data base and, where practicable, search terms used)

CNTXT: ENTXT; DWPI; WPABS; CNKI: 玻璃, 第二区域, 金属, 壳, 透过率, 一体成型; glass, all in one, intergrated molding, cover, housing, metal, second area, transmittance

**C. DOCUMENTS CONSIDERED TO BE RELEVANT**

| Category* | Citation of document, with indication, where appropriate, of the relevant passages | Relevant to claim No. |
| --- | --- | --- |
| PX | CN 116406106 A (HUAWEI TECHNOLOGIES CO., LTD.) 07 July 2023 (2023-07-07) claims 1-24 | 1-24 |
| X | CN 215867092 U (SZ DJI TECHNOLOGY CO., LTD.) 18 February 2022 (2022-02-18) description, paragraphs 0028-0118, and figures 1-16 | 1, 22 |
| A | CN 102347432 A (OCEAN'S KING LIGHTING SCIENCE & TECHNOLOGY CO., LTD. et al.) 08 February 2012 (2012-02-08) entire document | 1-24 |
| A | JP 2013077809 A (HOYA CORP.) 25 April 2013 (2013-04-25) entire document | 1-24 |
| A | US 2009065784 A1 (SEMICONDUCTOR ENERGY LABORATORY CO., LTD.) 12 March 2009 (2009-03-12) entire document | 1-24 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **21 December 2023** | **21 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/134509** |

| Patent document cited in search report | | | Publication date (day/month/year) | Patent family member(s) | | | Publication date (day/month/year) |
| --- | --- | --- | --- | --- | --- | --- | --- |
| CN | 116406106 | A | 07 July 2023 | None | | | |
| CN | 215867092 | U | 18 February 2022 | None | | | |
| CN | 102347432 | A | 08 February 2012 | None | | | |
| JP | 2013077809 | A | 25 April 2013 | None | | | |
| US | 2009065784 | A1 | 12 March 2009 | JP | 2009081425 | A | 16 April 2009 |
| | | | | JP | 5395384 | B2 | 22 January 2014 |
| | | | | US | 2010304515 | A1 | 02 December 2010 |
| | | | | US | 8420462 | B2 | 16 April 2013 |
| | | | | US | 7791075 | B2 | 07 September 2010 |

Form PCT/ISA/210 (patent family annex) (July 2022)

27

**EP 4 651 647 A1**

**REFERENCES CITED IN THE DESCRIPTION**

**Patent documents cited in the description**

- CN 202310201364